Europäisches Patentamt

European Patent Office

Office européen des brevets

(11) Veröffentlichungsnummer: **0 075 711**
**A2**

# (12) EUROPÄISCHE PATENTANMELDUNG

(21) Anmeldenummer: **82107492.9**

(22) Anmeldetag: **17.08.82**

(51) Int. Cl.$^3$: **G 11 C 15/00**

(30) Priorität: **30.09.81 DE 3138993**

(43) Veröffentlichungstag der Anmeldung:
**06.04.83 Patentblatt 83/14**

(84) Benannte Vertragsstaaten:
**AT DE FR GB**

(71) Anmelder: **SIEMENS AKTIENGESELLSCHAFT**
**Berlin und München Wittelsbacherplatz 2**
**D-8000 München 2(DE)**

(72) Erfinder: **Zehner, Bernd Dr.**
**Siedlerstrasse 2b**
**D-8150 Holzkirchen(DE)**

(54) **Speicherzelle, Assoziativspeicher und Verfahren zu deren Betrieb.**

(57) Eine Speicherzelle mit einer RAM-Zelle (R), welche für einen Assoziativspeicher geeignet ist, soll mit wenig Transistorstufen, mit geringen Verzögerungszeiten und mit wenig Verdrahtungsaufwand auskommen. Erfindungsgemäß weist eine Speicherzelle der eingangs genannten Art je zwei Anschlüsse an eine Wortleitung ($W_i$), an eine Bitleitung ($B_j$) und an eine weitere Bitleitung ($\overline{B_j}$) sowie fünf Transistoren (T1, T2, T3, E1, E2) und eine RAM-Zelle (R) auf. Die Elemente einer erfindungsgemäßen Speicherzelle sind so geschaltet, daß bei aktivierter Wortleitung ($W_i$) in die RAM-Zelle (R) eingeschrieben wird. Bei nicht-aktivierter Wortleitung ($W_i$) können Informationen mit der in der RAM-Zelle (R) gespeicherten Information verglichen werden.

EP 0 075 711 A2

**0075711**

SIEMENS AKTIENGESELLSCHAFT          Unser Zeichen
Berlin und München                  VPA  81 P 7 1 5 9 E

Speicherzelle, Assoziativspeicher und Verfahren zu deren
Betrieb.

Die Erfindung betrifft eine Speicherzelle nach dem Oberbegriff des Anspruchs 1.

Bei hochintegrierten Mikrokomputern werden schnelle
Speicher mit entsprechenden Speicherzellen benötigt.

Ein Assoziativspeicher (CAM = content addressable memory)
benötigt RAM-Speicherzellen, in welche eine Information
eingeschrieben werden kann, wobei diese Information später mit einer weiteren Information verglichen werden
kann. Das Ergebnis solcher Vergleiche muß in Form eines
Signals gegeben werden können.

Nach dem Stand der Technik ist es bekannt, zum Einschreiben von Informationen RAM-Zellen zu verwenden, wobei
diese RAM-Zellen an aufwendige Vergleichsschaltungen zum
Vergleichen von eingespeicherten Informationen mit weiteren Informationen angeschlossen sind. Bekannte Speicherzellen, welche als Speicherzellen für einen Assoziativspeicher verwendbar sind, weisen viele Transistorstufen
und damit lange Verzögerungszeiten beim Ausführen von
Operationen auf. Außerdem ist bei bekannten Speicherzellen, welche für Assoziativspeicher verwendet werden können, ein großer Verdrahtungsaufwand nötig.

Der vorliegenden Erfindung liegt die Aufgabe zugrunde,
eine Speicherzelle der eingangs genannten Art anzugeben, welche mit wenig Transistorstufen, mit geringen Verzögerungszeiten und mit wenig Verdrahtungsaufwand auskommt.

My 1 Bla / 29.9.1981

Diese Aufgabe wird erfindungsgemäß durch eine Speicherzelle der eingangs genannten Art gelöst, welche die kennzeichnenden Merkmale des Anspruchs 1 aufweist.

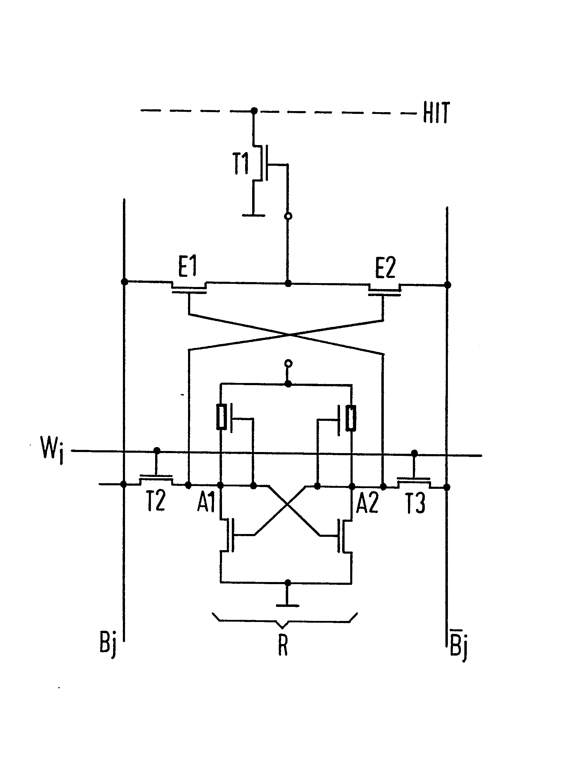

Ausgestaltungen und Vorteile der Erfindung sind in den Unteransprüchen, der Beschreibung und der Zeichnung dargestellt.

Eine erfindungsgemäße Speicherzelle weist bei sehr geringem Verdrahtungsaufwand sowohl Funktionen einer RAM-Zelle als auch Funktionen eines EXOR-Gatters auf.

Bei einer erfindungsgemäßen Speicherzelle werden zwischen dem Anlegen einer mit dem Inhalt der Speicherzelle zu vergleichenden Information und der Übergabe des Ergebnisses dieses Vergleichs an eine Trefferleitung (HIT) nur zwei Verzögerungszeiten benötigt, da nur zwei Transistorstufen bei der Durchführung dieser Operation angesprochen werden.

Die Erfindung ist in der Zeichnung dargestellt und wird im folgenden näher erläutert.

Die Figur zeigt eine erfindungsgemäße Speicherzelle.

Die in der Figur gezeigte Speicherzelle mit einer RAM-Zelle R weist zwei Anschlüsse an eine Wortleitung $W_i$ auf, wobei die Wortleitung $W_i$ an die Steuerelektroden der Transistoren T2, T3 angeschlossen ist. Die Bitleitung $B_j$ ist an eine weitere Elektrode des Transistors T2 und an eine Elektrode des Transistors E1 angeschlossen. Die Bitleitung $\overline{B}_j$ weist als Signal das invertierte Signal der Bitleitung $B_j$ auf. Die Bitleitung $\overline{B}_j$ ist an eine Elektrode des Transistors T3 und an eine Elektrode des Transistors E2 angeschlossen. Die Elektrode A1 der RAM-Zelle R ist an die dritte Elektrode des Transistors T2 und an die Steuerelektrode des Transistors E2 angeschlossen. Die Elektrode A2 der RAM-Zelle R ist an eine Elektrode des Transistors T3 und an die Steuerelektrode des Transistors E1 angeschlossen. Je eine Elektrode der Transistoren E1, E2 sind an die Steuerelektrode des Transistors T1 angeschlossen. Über die Steuerelektrode des Transistors T1 wird das an der Trefferleitung HIT anliegende Signal gesteuert.

Bei aktivierter Wortleitung $W_i$ wird die an der Bitleitung $B_j$ anliegende Information in die RAM-Zelle R eingeschrieben. Bei nicht-aktivierter Wortleitung $W_i$ wird die an der Bitleitung $B_j$ anliegende Information mit der in der RAM-Zelle R gespeicherten Information verglichen. Das Ergebnis dieses Vergleichs wird über die Steuerelektrode des Transistors T1 an die Trefferleitung HIT gegeben. Stimmt bei diesem Vergleich die an der Bitleitung $B_j$ anliegende Information mit dem Inhalt der RAM-Zelle R überein, so wird ein an der Trefferleitung HIT anliegendes positives Signal nicht verändert. Stimmt bei einem solchen Vergleich die an der Bitleitung $B_j$ anliegende Information nicht mit dem Inhalt der RAM-Zelle R überein, so wird ein positives Signal der Trefferleitung HIT nicht ermöglicht.

Mit einer matrixförmigen Anordnung von erfindungsgemäßen Speicherzellen in i-Zeilen und j-Spalten kann ein Assoziativspeicher aufgebaut werden. Dabei können in den i-Zeilen i-Worte $M_i$ mit jeweils j-Bits $N_{ij}$ pro Wort gespeichert werden. Ein solcher Assoziativspeicher, welcher aus erfindungsgemäßen Speicherzellen aufgebaut ist, weist eine reguläre Struktur und einen sehr geringen Verdrahtungsaufwand auf. Diese beiden Eigenschaften sind bei hochintegrierten Schaltungen sehr wichtig, um in kostengünstiger Weise schnelle VLSI-Schaltungen realisieren zu können.

Eine erfindungsgemäße Speicherzelle ermöglicht die kostengünstige Realisierung eines schnellen Assoziativspeichers. Bei der zeilenweisen Anordnung (Zeile i) von erfindungsgemäßen Speicherzellen wird in der Zeile i keine zusätzliche Verdrahtung benötigt. Der Transistor T1 einer erfindungsgemäßen Speicherzelle bildet dabei den Teil eines NOR-Gatters, welches sich über die ganze Zeile i hinweg erstreckt. Ein zu vergleichendes Wort $M_k$ wird mit den in einem Assoziativspeicher gespeicherten Worten $M_i$ parallel über die Bitleitungen $B_j$, $\overline{B}_j$ verglichen. Ist ein bestimmtes Wort $M_k$ in einer bestimmten Zeile des Assoziativspeichers gespeichert, so bleibt die Trefferleitung HIT dieser Zeile aktiviert. Wenn durch die Ladestrategie des Assoziativspeichers gewährleistet ist, daß ein bestimmtes Wort höchstens einmal im Assoziativspeicher gespeichert werden kann, so ermöglicht es ein erfindungsgemäßer Assoziativspeicher in einfacher Weise, Mittel zur Anzeige dafür vorzusehen, daß das bestimmte Wort in einer Zeile gespeichert ist. Beispielsweise können sämtliche Trefferleitungen HIT von allen Zeilen eines erfindungsgemäßen Assoziativspeichers in einem NOR-Gatter miteinander verknüpft werden.

Eine erfindungsgemäße Speicherzelle ermöglicht eine platzsparende Realisierung eines Speichers.

Pro Zeile i eines erfindungsgemäßen Assoziativ-speichers ist zwischen Versorgungsspannung und der Trefferleitung HIT je ein Lasttransistor geschaltet, welcher in der Zeichnung nicht dargestellt ist.

8 Patentansprüche
1 Figur

0075711

81 P 7159 E

Patentansprüche:

1. Speicherzelle mit einer RAM-Zelle (R), welche für einen Assoziativ-speicher geeignet ist, g e - k e n n z e i c h n e t durch

a) zwei Anschlüsse an eine Wortleitung ($W_i$), wobei die Wortleitung ($W_i$) an die Steuerelektroden zweier Transistoren (T2, T3) angeschlossen ist,

b) zwei Anschlüsse an eine Bitleitung ($B_j$), wobei die Bitleitung ($B_j$) an eine weitere Elektrode des Transistors (T2) und an eine Elektrode eines weiteren Transistors (E1) angeschlossen ist,

c) zwei Anschlüsse an eine weitere Bitleitung ($\overline{B}_j$), die das invertierte Signal der anderen Bitleitung ($B_j$) als Signal aufweist, wobei diese weitere Bitleitung ($\overline{B}_j$) an eine weitere Elektrode des Transistors (T3) und an eine Elektrode des Transistors (E2) angeschlossen ist,

d) Anschlüsse der einen Elektrode (A1) der RAM-Zelle (R) an die dritte Elektrode des Transistors (T2) und an die Steuerelektrode des Transistors (E2) und der anderen Elektrode (A2) der RAM-Zelle (R) an die dritte Elektrode des Transistors (T3) und an die Steuerelektrode des Transistors (E1),

e) Anschlüsse der jeweils dritten Elektroden der Transistoren (E1, E2) an die Steuerelektrode eines Transistors (T1),

f) Steuerung einer Trefferleitung (HIT) über die Steuerelektrode des Transistors (T1).

2. Verfahren zum Betrieb einer Speicherzelle nach Anspruch 1, dadurch g e k e n n z e i c h n e t , daß bei aktivierter Wortleitung ($W_i$) die an der Bitleitung ($B_j$) anliegende Information in die RAM-Zelle (R) eingeschrieben wird.

3. Verfahren zum Betrieb einer Speicherzelle nach Anspruch 1 oder 2, dadurch g e k e n n z e i c h n e t , daß bei nicht-aktivierter Wortleitung ($W_i$) die an der Bitleitung ($B_j$) anliegende Information mit der in der RAM-Zelle (R) gespeicherten Information verglichen wird, wobei das Ergebnis dieses Vergleichs über die Steuerelektrode des Transistors (T1) an eine Trefferleitung (HIT) gegeben wird.

4. Assoziativspeicher mit Speicherzelle nach Anspruch 1 bis 3, g e k e n n z e i c h n e t durch i-Zeilen mit jeweils j-Speicherzellen.

5. Assoziativspeicher nach Anspruch 4, g e k e n n - z e i c h n e t durch die Speicherung von i-Worten ($M_i$) zu je j-Bits ($N_{ij}$).

6. Assoziativspeicher nach Anspruch 4 oder 5, g e - k e n n z e i c h n e t durch je ein NOR-Gatter pro Zeile bestehend aus der Trefferleitung (HIT) und den Transistoren (T1) derjenigen Speicherzellen, welche die betreffende Zeile bilden, sowie einem Lasttransistor zwischen Versorgungsspannung und der Trefferleitung (HIT).

7. Assoziativspeicher nach Anspruch 4 bis 6, g e - k e n n z e i c h n e t durch Mittel zur Anzeige dafür, daß ein bestimmtes Wort ($M_k$) in einer Zeile gespeichert ist.

8. Verfahren zum Betrieb eines Assoziativspeichers nach Anspruch 4 bis 7, dadurch g e k e n n z e i c h n e t , daß ein bestimmtes Wort ($M_k$) mit allen gespeicherten Worten ($M_i$) parallel verglichen wird.